# EUROPEAN PATENT SPECIFICATION

(11) **EP 3 413 362 B1**
(45) Date of publication and mention of the grant of the patent: **16.10.2019**
(21) Application number: 18176489.5
(22) Date of filing: 07.06.2018
(51) Int. Cl.: H01L 41/08, H01L 41/187, B41J 2/14

(54) **PIEZOELECTRIC ELEMENT AND PIEZOELECTRIC ELEMENT APPLIED DEVICE**
PIEZOELEKTRISCHES ELEMENT UND VORRICHTUNG MIT ANGEBRACHTEM PIEZOELEKTRISCHEM ELEMENT
ÉLÉMENT PIÉZOÉLECTRIQUE ET ÉLÉMENT PIÉZOÉLECTRIQUE APPLIQUÉ À UN DISPOSITIF

(30) Priority: 09.06.2017 JP 2017114181
(43) Date of publication of application: 12.12.2018
(73) Proprietor: Seiko Epson Corporation, Tokyo 160-8801 (JP)
(72) Inventor: KITADA, Kazuya, Suwa-shi, Nagano 392-8502 (JP)
(74) Representative: Miller Sturt Kenyon

(56) References cited:
- US-A1- 2006 118 840
- US-A1- 2011 143 146
- US-A1- 2014 035 439
- US-A1- 2017 062 693

## Description

### BACKGROUND

### 1. Technical Field

The present invention relates to a piezoelectric element which includes a first electrode, a piezoelectric layer, and a second electrode, and a piezoelectric element applied device which includes the piezoelectric element.

### 2. Related Art

Generally, a piezoelectric element includes a piezoelectric layer and two electrodes. The piezoelectric layer has electromechanical conversion characteristics. The piezoelectric layer is interposed between the two electrodes. A device (piezoelectric element applied device) which uses such a piezoelectric element as a driving source has recently been actively developed. As one of the piezoelectric element applied devices, for example, a liquid ejecting head represented by an ink jet recording head, a MEMS element represented by a piezoelectric MEMS element, an ultrasonic measurement device represented by an ultrasonic sensor and the like, and a piezoelectric actuator device are provided.

As a material (piezoelectric material) of the piezoelectric layer of the piezoelectric element, lead zirconate titanate (PZT) is known. However, from a viewpoint of an environmental problem, a piezoelectric material which does not contain lead or a piezoelectric material in which the content of lead is suppressed has been required. As the piezoelectric material which does not contain lead, for example, a potassium sodium niobate (KNN)-based piezoelectric material which contains K, Na, and Nb is provided. The KNN-based material has a problem in that a leakage current is generated. However, a technology in which a rare-earth element is added as measures for securing the insulating property is proposed (see JP-A-2013-225605).

However, a problem that crystals are not oriented but randomly oriented, or heterogeneity appears occurs depending on the type or the amount of the additive. Thus, it is difficult to secure the insulating property while orientation is maintained without heterogeneity appearing.

Such a problem is not limited to a piezoelectric element used in a piezoelectric actuator which is mounted in a liquid ejecting head represented by an ink jet recording head, and similarly also occurs in a piezoelectric element used in other piezoelectric element applied devices.

US2006/118840 discloses an electrically stable PbLa0.5TiO3/PbZr0.52Ti0.48O3 (PLT/PZT) ferroelectric structure that may be fabricated using precursor solutions formed using a simple sol-gel process. The PLT/PZT ferroelectric structure may be extended to a PLT/PZT/PLT ferroelectric capacitor structure. In terms of device application, better ferroelectric properties with reliable fatigue characteristics are desirable to render satisfactory performance and long device life. The PLT/PZT/PLT ferroelectric capacitor structure excels over previous hybrid structures by providing a larger remnant polarization, higher saturation polarization, lower coercive field and leakage current density and higher resistance to fatigue. The fabrication method involving the use of a PLT seeding layer acts to lower the fabrication temperature of the subsequent PZT layer and allows for a simpler sequence of processing steps that may be seen to substantially reduce manufacturing costs.

US2011/143146 discloses a piezoelectric thin film including a lead-free ferroelectric material and exhibiting high piezoelectric performance comparable to that of lead zirconate titanate (PZT), and a method of manufacturing the piezoelectric thin film. The piezoelectric thin film comprises a LaNiO3 film having a (001) orientation; a NaNbO3 film having a (001) orientation; and a (Bi, Na, Ba) TiO3 film having a (001) orientation. The LaNiO3 film, the NaNbO3 film, and the (Bi, Na, Ba)TiO3 film are laminated in this order.

US2014/035439 discloses a piezoelectric device provided with a first electrode film, a first nonmetal electroconductive intermediate film provided on the first electrode film, a piezoelectric film provided on the first nonmetal electroconductive intermediate film, a second nonmetal electroconductive intermediate film provided on the piezoelectric film, and a second electrode film provided on the second nonmetal electroconductive intermediate film. A linear expansion coefficient of the first nonmetal electroconductive intermediate film is larger than those of the first electrode film and the piezoelectric film, and a linear expansion coefficient of the second nonmetal electroconductive intermediate film is larger than those of the second electrode film and the piezoelectric film.

US2017/062693 discloses a piezoelectric element which includes a first electrode, a piezoelectric layer which is formed on the first electrode by using a solution method, and is formed from a compound oxide having a perovskite structure in which potassium, sodium, and niobium are provided, and a second electrode which is provided on the piezoelectric layer. A cross-sectional SEM image of the piezoelectric layer is captured at a magnification of 100,000. When evaluation is performed under a condition in which a measured value in a transverse direction is set to 1,273 nm, two or more voids are included in the piezoelectric layer, a difference between the maximum value and the minimum value among diameters of the voids to be largest in a film thickness direction is equal to or smaller than 14 nm, and the maximum value is equal to or smaller than 24 nm.

### SUMMARY

An advantage of some aspects of the invention is to provide a piezoelectric element and a piezoelectric element applied device which includes a KNN-based piezoelectric layer having excellent leakage characteristics.

According to an aspect of the invention, there is provided a piezoelectric element as defined in claim 1.

In this case, the piezoelectric layer formed of the perovskite type oxide including at least one selected from the group consisting of potassium, sodium, bismuth, and niobium is configured to be interposed between the first perovskite layer and the second perovskite layer formed of perovskite type oxides having compositions different from that of the piezoelectric layer. Thus, excellent leakage characteristics are obtained.

Further, since the piezoelectric layer formed of the perovskite type oxide includes at least one selected from the group consisting of potassium, sodium, bismuth, and niobium is configured to be interposed between the first perovskite layer and the second perovskite layer formed of the perovskite type oxides including at least one selected from the group consisting of bismuth and iron, excellent leakage characteristics are obtained.

In the piezoelectric element, it is preferable that the piezoelectric layer be preferentially oriented to a (100) plane. In this case, a piezoelectric layer which has particularly excellent piezoelectric characteristics is obtained.

In the piezoelectric element, the first perovskite layer is formed of the perovskite type oxide including bismuth or iron, and be preferentially oriented to a (100) plane. In this case, it is possible to relatively easily perform orientation of the piezoelectric layer to the (100) plane.

In the piezoelectric element, it is preferable that an orientation control layer is provided between the first electrode and the first perovskite layer or between the first perovskite layer and the piezoelectric layer. In this case, it is possible to relatively easily perform orientation of the piezoelectric layer to the (100) plane.

In the piezoelectric element, the second perovskite layer is formed of the perovskite type oxide including bismuth or iron, and be preferentially oriented to a (100) plane. In this case, a piezoelectric element having particularly excellent piezoelectric characteristics is obtained.

In the piezoelectric element, it is preferable that each of the first perovskite layer and the second perovskite layer be thinner than the piezoelectric layer. Accordingly, it is possible to realize a piezoelectric element having improved piezoelectric characteristics.

In the piezoelectric element, it is preferable that the first electrode and the second electrode be formed of at least one material selected from Pt, Ir, and oxides thereof. Accordingly, it is possible to realize a piezoelectric element having improved piezoelectric characteristics.

In the piezoelectric element, it is preferable that the piezoelectric element further-include a layer which is formed of zirconium or zirconium oxide and is provided between a substrate on which the first electrode is provided, and the first electrode. In this case, it is possible to prevent permeation of alkali metal into the substrate, and to realize a piezoelectric element having improved piezoelectric characteristics.

According to another aspect of the invention, there is provided a piezoelectric element applied device including the piezoelectric element.

In this case, it is possible to realize a piezoelectric element applied device having excellent leakage characteristics.

### BRIEF DESCRIPTION OF THE DRAWINGS

Embodiments of the invention will now be described by way of example only with reference to the accompanying drawings, wherein like numbers reference like elements.
Fig. 1 is a diagram illustrating a schematic configuration of a recording apparatus.
Fig. 2 is an exploded perspective view illustrating a recording head.
Fig. 3 is a plan view illustrating the recording head.
Fig. 4 is a cross-sectional view illustrating the recording head.
Fig. 5 is a sectional view illustrating a manufacturing example of the recording head.
Fig. 6 is a sectional view illustrating the manufacturing example of the recording head.
Fig. 7 is a sectional view illustrating the manufacturing example of the recording head.
Fig. 8 is a sectional view illustrating the manufacturing example of the recording head.
Fig. 9 is a sectional view illustrating the manufacturing example of the recording head.
Fig. 10 is a sectional view illustrating the manufacturing example of the recording head.
Fig. 11 is a sectional view illustrating the manufacturing example of the recording head.
Fig. 12 is a diagram illustrating a hysteresis curve in Example 1.
Fig. 13 is a diagram illustrating a hysteresis curve in Comparative Example 1.
Fig. 14 illustrates XRD in Example 1.
Fig. 15 illustrates XRD in Example 2.

### DESCRIPTION OF EXEMPLARY EMBODIMENTS

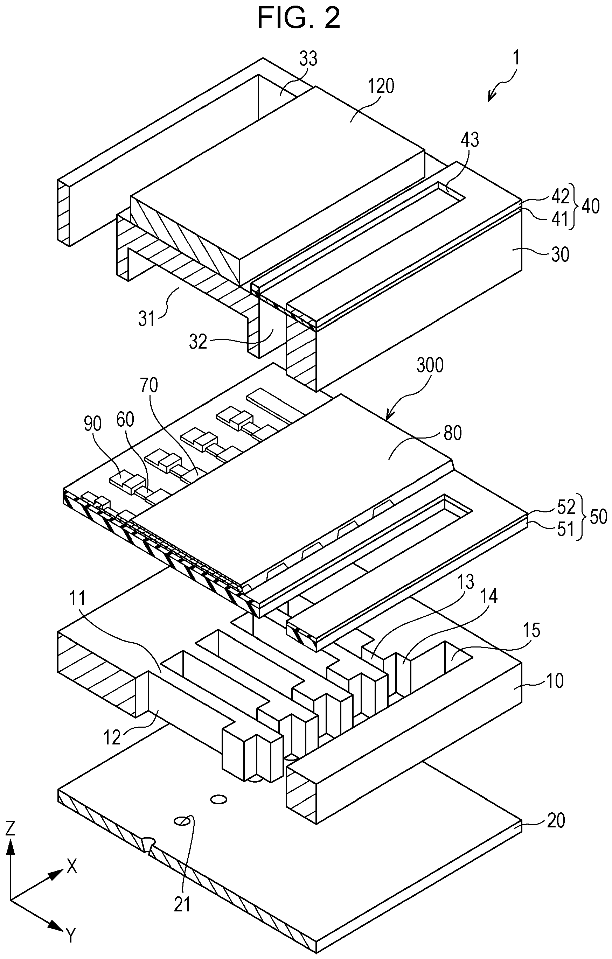

Hereinafter, an embodiment according to the invention will be described with reference to the drawings. The following descriptions are used for describing an aspect of the invention and may be arbitrarily changed in a range of the invention. In the drawings, components denoted by the same reference numerals indicate the same member as each other, and descriptions thereof will be appropriately omitted. In Figs. 2 to 11, X, Y, and Z indicate three spatial axes perpendicular to each other. In the specification, descriptions will be made by using directions along the three spatial axes, which are respectively set as an X direction, a Y direction, and a Z direction. The Z direction indicates a thickness direction or a layered direction of a plate, a layer, and a film. The X direction and the Y direction indicate an in-plane direction of the plate, the layer, and the film.

### Embodiment 1

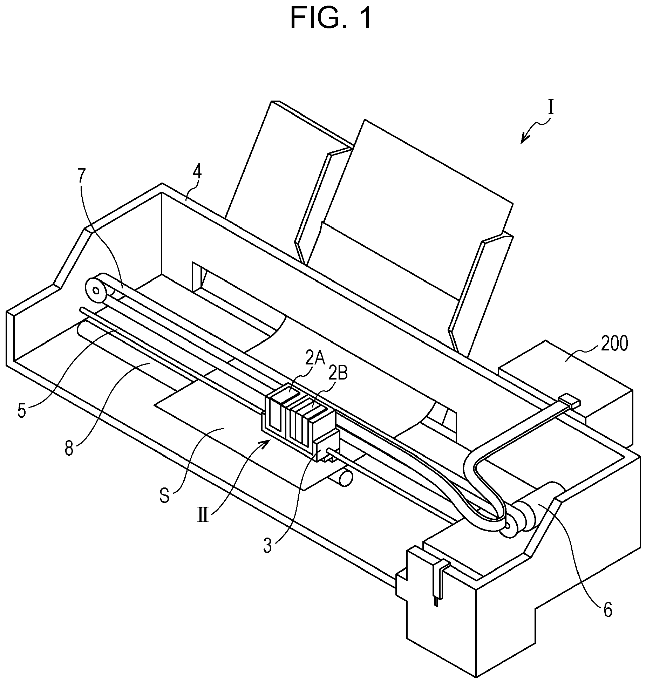

Fig. 1 illustrates an ink jet type recording apparatus which is an example of a liquid ejecting apparatus. The liquid ejecting apparatus includes a recording head which is an example of a piezoelectric element applied device according to an embodiment of the invention. As illustrated in Fig. 1, in an ink jet type recording apparatus I, an ink jet recording head unit (head unit) II which includes a plurality of ink jet recording heads is provided so as to be attachable to cartridges 2A and 2B. The cartridges 2A and 2B constitute an ink supply section. A carriage 3 having the head unit II mounted therein is provided with a carriage shaft 5 so as to be movable in a shaft direction. The carriage shaft 5 is attached to a main body 4 of the apparatus. For example, the carriage 3 has a function of discharging a black ink composite and a color ink composite.

A driving force of a driving motor 6 is transferred to the carriage 3 through a plurality of gears and timing belts 7 (not illustrate). Thus, the carriage 3 having the head unit II mounted therein is moved along the carriage shaft 5. A transporting roller 8 is provided as a transporting section in the main body 4 of the apparatus. A recording sheet S which is a recording medium such as paper is transported by the transporting roller 8. The transporting section that transports the recording sheet S is not limited to the transporting roller, and may be a belt, a drum, or the like.

According to such an ink jet type recording apparatus I, since the ink jet type recording apparatus I includes the ink jet recording head (simply also referred to the "recording head" below), it is possible to manufacture the ink jet type recording apparatus I cheaply. Because improvement of displacement characteristics of the piezoelectric element constituting a piezoelectric actuator is expected, it is possible to improve ejecting characteristics.

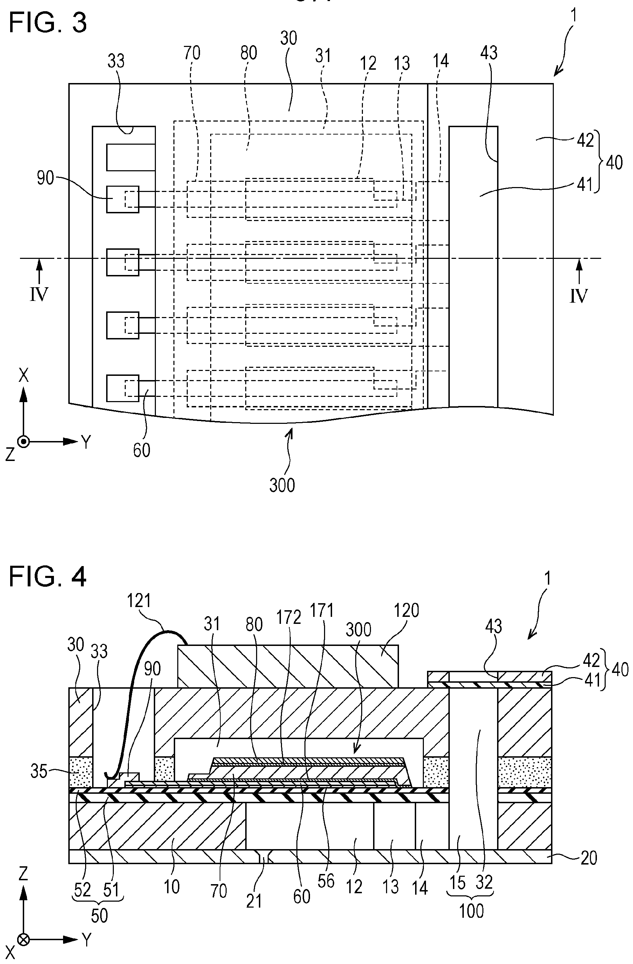

An example of a recording head 1 mounted in the above-described ink jet type recording apparatus I will be described with reference to Figs. 2 to 4. Fig. 2 is an exploded perspective view illustrating the recording head which is an example of a liquid ejecting unit according to the embodiment. Fig. 3 is a plan view of a piezoelectric element side of a passage formation substrate. Fig. 4 is a cross-sectional view taken along line IV-IV in Fig. 3.

The passage formation substrate 10 (referred to as a "substrate 10") is formed from, for example, a silicon single crystal substrate. In the passage formation substrate 10, pressure generation chambers 12 are formed. In each of the pressure generation chambers 12 obtained by subdivision with a plurality of partitions 11, a plurality of nozzle openings 21 for discharging an ink of the same color are arranged in the X direction.

In the substrate 10, an ink supply path 13 and a communication path 14 are formed on one end portion side of the pressure generation chamber 12 in the Y direction. The ink supply path 13 is configured in such a manner that one side of the pressure generation chamber 12 is narrowed from the X direction and thus an opening area of the pressure generation chamber 12 becomes small. The communication path 14 has substantially the same width as the pressure generation chamber 12 in the X direction. A communication portion 15 is formed on the outside (+Y direction side) of the communication path 14. The communication portion 15 constitutes a portion of a manifold 100. The manifold 100 functions as a common ink chamber for the pressure generation chambers 12. In this manner, a fluid passage which is formed from the pressure generation chamber 12, the ink supply path 13, the communication path 14, and the communication portion 15 is formed in the substrate 10.

For example, a SUS nozzle plate 20 is bonded to one surface (surface on a -Z direction side) of the substrate 10. The nozzle openings 21 are arranged in the nozzle plate 20 in the X direction. The nozzle openings 21 respectively communicate with the pressure generation chambers 12. The nozzle plate 20 may be bonded to the substrate 10 by using an adhesive, a heat-welding film, or the like.

A vibration plate 50 is formed on another surface (surface on a +Z direction) of the substrate 10. The vibration plate 50 includes, for example, an elastic film 51 formed on the substrate 10, and an insulating film 52 formed on the elastic film 51. The elastic film 51 is formed of silicon dioxide (SiO₂), for example. The insulating film 52 is formed of zirconium dioxide (ZrO₂), for example. The elastic film 51 may not be a member separate from the substrate 10. A portion of the substrate 10 is processed so as to be thin, and a part obtained by the processing may be used as the elastic film.

A piezoelectric element 300 which includes a first electrode 60, a piezoelectric layer 70, and a second electrode 80 is formed on the insulating film 52 with an adhesive layer 56 interposed between the piezoelectric element 300. The adhesive layer 56 is used for improving adhesiveness between the first electrode 60 and the substrate. The adhesive layer 56 may be formed by using, for example, titanium oxide (TiO_{X}), titanium (Ti), silicon nitride (SiN), or the like. The adhesive layer 56 may be omitted. An orientation control layer (also referred to as a seed layer) for controlling an orientation of the piezoelectric layer 70 may be provided on the adhesive layer 56 or in a configuration in which the adhesive layer 56 is omitted.

In the embodiment, displacement of the piezoelectric layer 70 having electromechanical conversion characteristics causes displacement to occur in the vibration plate 50 and the first electrode 60. That is, in the embodiment, the vibration plate 50 and the first electrode 60 substantially have a function as a vibration plate. The elastic film 51 and the insulating film 52 may be omitted and only the first electrode 60 may function as the vibration plate. In a case where the first electrode 60 is directly provided on the substrate 10, the first electrode 60 is preferably protected by using an insulating protective film and the like, so as not to bring an ink into contact with the first electrode 60.

The piezoelectric layer 70 is provided between the first electrode 60 and the second electrode 80. The piezoelectric layer 70 is formed so as to have a width wider than the first electrode 60 in the X direction. The piezoelectric layer 70 in the Y direction is formed so as to have a width wider than the length of the pressure generation chamber 12 in the Y direction. An end portion (end portion in the +Y direction) of the ink supply path 13 side of the piezoelectric layer 70 in the Y direction is formed over the outside of an end portion of the first electrode 60. That is, another end portion (end portion on the +Y direction side) of the first electrode 60 is covered with the piezoelectric layer 70. One end portion (end portion on a -Y direction side) of the piezoelectric layer 70 is provided on the inner side of one end portion (end portion on the -Y direction side) of the first electrode 60. That is, the one end portion (end portion on the -Y direction side) of the first electrode 60 is not covered with the piezoelectric layer 70.

The second electrode 80 is provided over the piezoelectric layer 70, the first electrode 60, and the vibration plate 50 in the X direction. That is, the second electrode 80 is configured as a common electrode which is commonly used for a plurality of piezoelectric layers 70. Instead of the second electrode 80, the first electrode 60 may be used as the common electrode.

A protective substrate 30 is bonded to the substrate 10 in which the piezoelectric element 300 is formed, by using an adhesive 35. The protective substrate 30 includes a manifold portion 32. At least a portion of the manifold 100 is configured by the manifold portion 32. The manifold portion 32 according to the embodiment is formed in a width direction (X direction) of the pressure generation chamber 12, so as to pass through the protective substrate 30 in a thickness direction (Z direction). As described above, the manifold portion 32 communicates with the communication portion 15 of the substrate 10. With the configuration, the manifold 100 which functions as the common ink chamber for the pressure generation chambers 12 is configured.

A piezoelectric element holding portion 31 is formed in an area including the piezoelectric element 300 in the protective substrate 30. The piezoelectric element holding portion 31 has a space which is large enough not to impede the movement of the piezoelectric element 300. The space may be sealed or may not be sealed. A through-hole 33 which passes through the protective substrate 30 in the thickness direction (Z direction) is provided in the protective substrate 30. An end portion of the lead electrode 90 is exposed in the through-hole 33.

A driving circuit 120 which functions as a signal processing unit is fixed to the protective substrate 30. The driving circuit 120 may use, for example, a circuit board or a semiconductor integrated circuit (IC). The driving circuit 120 and the lead electrode 90 are electrically connected to each other through a connection wire 121. The driving circuit 120 may be electrically connected to a printer controller 200. Such a driving circuit 120 functions as a control section according to the embodiment.

A compliance substrate 40 which is formed from a sealing film 41 and a fixation plate 42 is bonded to the protective substrate 30. An area of the fixation plate 42, which faces the manifold 100, functions as an opening portion 43 obtained by completely removing the fixation plate 42 in the thickness direction (Z direction). One surface (surface on the +Z direction side) of the manifold 100 is sealed only by the sealing film 41 having flexibility.

Next, details of the piezoelectric element 300 will be described. The piezoelectric element 300 includes the first electrode 60, the second electrode 80, and the piezoelectric layer 70 provided between the first electrode 60 and the second electrode 80. The thickness of the first electrode 60 is about 50 nm. The piezoelectric layer 70 is a so-called thin-film piezoelectric body. That is, the piezoelectric layer 70 has a thickness of 50 nm to 2000 nm. The thickness of the second electrode 80 is about 50 nm. The value of the thickness of the constituents exemplified herein is only an example and may be changed in a range without deviating from the gist of the invention.

As the material of the first electrode 60 and the second electrode 80, precious metal such as platinum (Pt) and iridium (Ir) or oxides thereof are suitable. The material of the first electrode 60 and the material of the second electrode 80 may be materials having conductivity. The material of the first electrode 60 and the material of the second electrode 80 may be the same as each other or may be different from each other.

The piezoelectric layer 70 is formed by a thin film as described above and is formed by a solution method (also referred to as a liquid phase method or a wet type method) such as a MOD method and a sol-gel method, or by a vapor phase method such as a sputtering method. In the embodiment, the piezoelectric layer 70 is formed by using a solution method and is formed of a perovskite type oxide which is represented by a general formula ABO₃ and includes potassium (K), sodium (Na), and niobium (Nb).

The piezoelectric layer 70 is formed of a compound oxide having a perovskite structure which is represented by a general formula ABO₃, and includes potassium (K), sodium (Na), and niobium (Nb). That is, the piezoelectric layer 70 includes a piezoelectric material formed of a KNN-based compound oxide represented by Formula (1).

(K_{X}, Na_{1-X})NbO₃ ... (1)

(0.1≤X≤0.9)

The compound oxide represented by Formula (1) is so-called a KNN-based compound oxide. The KNN-based compound oxide is a non-lead-based piezoelectric material in which the content of lead (Pb) and the like is reduced, and thus has excellent biocompatibility and has a small environmental load. Because the KNN-based compound oxide has excellent piezoelectric characteristics among non-lead-based piezoelectric materials, the KNN-based compound oxide is advantageous for improving various types of characteristics. In addition, the KNN-based compound oxide has the Curie temperature higher than that of other non-lead-based piezoelectric materials (for example, BNT-BKT-BT; [(Bi, Na)TiO₃]-[(Bi, K)TiO₃]-[BaTiO₃]), and occurrence of depolarization due to an increase of a temperature is also difficult. Thus, using at a high temperature is possible.

In Formula (1), the content of K is preferably 30 mol% to 70 mol% with respect to the total amount of metal elements constituting an A site (in other words, the content of Na is 30 mol% to 70 mol% with respect to the total amount of the metal elements constituting the A site). That is, in Formula (1), 0.3≤x≤0.7 is preferably satisfied. According to this configuration, the compound oxide having a composition advantageous for the piezoelectric characteristics is obtained. The content of K is more preferably 40 mol% to 60 mol% with respect to the metal elements constituting the A site (in other words, the content of Na is 40 mol% to 60 mol% with respect to the total amount of the metal elements constituting the A site). That is, in Formula (1), 0.4≤x≤0.6 is more preferably satisfied. According to this configuration, the compound oxide having a composition which is more advantageous for the piezoelectric characteristics.

The piezoelectric material forming the piezoelectric layer 70 may be the KNN-based compound oxide and is not limited to the composition represented by the formula (1). For example, another metal element (additive) may be included in an A site or a B site of potassium sodium niobate. Examples of such an additive include manganese (Mn), lithium (Li), barium (Ba), calcium (Ca), strontium (Sr), zirconium (Zr), titanium (Ti), bismuth (Bi), tantalum (Ta), antimony (Sb), iron (Fe), cobalt (Co), silver (Ag), magnesium (Mg), zinc (Zn), and copper (Cu).

One or more types of this additive may be included. Generally, the amount of the additive is equal to or smaller than 20%, preferably equal to or smaller than 15%, and more preferably equal to or smaller than 10%, with respect to the total amount of an element which functions as the main component. Using the additive causes various types of characteristics to be improved, and thus configurations or functions are easily diversified. However, a piezoelectric material in which KNN is provided so as to be more than 80% is preferable from a viewpoint of showing characteristics which are derived from KNN. In a case where there is a compound oxide containing the above-described other elements, it is preferable that the ABO₃ type perovskite structure be also provided.

Alkali metal in the A site may be excessively added in comparison to the stoichiometric composition. The alkali metal in the A site may be insufficient than that in the stoichiometric composition. Thus, the compound oxide in the embodiment can be represented by Formula (2). In Formula (2), A indicates the amount of K and Na which may be excessively added or the amount of K and Na which may be insufficient. In a case where the amount of K and Na is excessive, 1.0<A is satisfied. In a case where the amount of K and Na is insufficient, A<1.0 is satisfied. For example, A=1.1 indicates that 110 mol% of K and Na is included when the amount of K and Na in the stoichiometric composition is set to 100 mol%. A=0.9 indicates that 90 mol% of K and Na is included when the amount of K and Na in the stoichiometric composition is set to 100 mol%. A case where the alkali metal in the A site is not excessive and not insufficient in comparison to the stoichiometric composition means A=1. From a viewpoint of improving the characteristics, 0.85≤A≤1.20 is satisfied, 0.90≤A≤1.15 is preferably satisfied, and 0.95≤A≤1.10 is more preferably satisfied.

(K_{AX}, Na_{A(1-X)})NbO₃... (2)

(0.1≤x≤0.9, preferably 0.3≤x≤0.7, and more preferably 0.4≤x≤0.6)

The piezoelectric material also includes a material having a composition in which some of elements are lack, a material having a composition in which some of elements are excessively provided, and a material having a composition in which some of elements are replaced with other elements. A material having a composition changed from the stoichiometric composition by deficiency or excess or a material in which some of elements are replaced with other elements is also included in the piezoelectric material according to the embodiment so long as basic characteristics of the piezoelectric layer 70 are not changed.

In the specification, "the compound oxide having an ABO₃ type perovskite structure including K, Na, and Nb" is not limited only to a compound oxide having an ABO₃ type perovskite structure including K, Na, and Nb. That is, in the specification, "the compound oxide having an ABO₃ type perovskite structure including K, Na, and Nb" includes a piezoelectric material which is represented as mixed crystal which contains a compound oxide having an ABO₃ type perovskite structure including K, Na, and Nb (for example, KNN-based compound oxide which is exemplified above) and other compound oxides having an ABO₃ type perovskite structure.

In the scope of the invention, other compound oxides are not limited. However, as the other compound oxides, a non-lead-based piezoelectric material which does not contain lead (Pb) is preferable. As the other compound oxides, a non-lead-based piezoelectric material which does not contain lead (Pb) and bismuth (Bi) is more preferable. If the compound oxide is used, the piezoelectric element 300 having excellent biocompatibility, and has a small environmental load is obtained.

In the piezoelectric layer 70 formed of the above-described compound oxide, crystals are oriented in (100) orientation in the embodiment. That is, the crystals are preferentially oriented to the (100) crystal plane. In the embodiment, the crystals are preferentially oriented to the (100) plane, and preferential orientation to the (100) plane is preferable from a viewpoint of the piezoelectric characteristics. In the specification, preferential orientation means that a crystal of which the content is equal to or greater than 50%, and preferably equal to or greater than 80% is oriented to a predetermined crystal plane. For example, "being preferentially orientated in (100) plane" includes a case where all crystals in the piezoelectric layer 70 are oriented to the (100) plane, and a case where crystals of the half or more (being equal to or greater than 50%, and preferably equal to or greater than 80%) are oriented to the (100) plane.

A first perovskite layer 171 is provided between the piezoelectric layer 70 and the first electrode 60. A second perovskite layer 172 is provided between the piezoelectric layer 70 and the second electrode 80.

Here, the first perovskite layer 171 and the second perovskite layer 172 are formed of perovskite type oxides including at least one selected from the group consisting of bismuth and iron. The first perovskite layer 171 and the second perovskite layer 172 may be formed of the same material or different materials.

The perovskite type oxide including at least one selected from the group consisting of bismuth and iron is selected from a perovskite type oxide which includes bismuth as an element in the A site and includes at least one selected from iron, cobalt, nickel, manganese, zinc, titanium, and the like as an element in the B site and a perovskite type oxide which includes at least one selected from bismuth, lanthanum, cerium, praseodymium, neodymium, samarium, europium, and the like as an element in the A site and includes iron as an element in the B site. In particular, a perovskite type oxide which includes bismuth as the element in the A site and includes iron as the element in the B site, that is, a BFO-based perovskite type oxide is preferable.

Since the first perovskite layer 171 and the second perovskite layer 172 have the above-described compositions, it is possible to improve leakage characteristics of the piezoelectric layer 70, as details thereof will be described later. If only improvement of the leakage characteristics is considered, the BFO-based perovskite type oxide is preferable. The first perovskite layer 171 and the second perovskite layer 172 not necessarily have piezoelectric characteristics, but a perovskite type oxide having the piezoelectric characteristics is preferable.

Such the first perovskite layer 171 and the second perovskite layer 172 have a thickness of 5 nm or greater, preferably 10 nm or greater, and more preferably 20 nm or greater, in order to improve the leakage characteristics. In a case where permittivity is particularly low, the first perovskite layer 171 and the second perovskite layer 172 contribute to substantial decrease of the piezoelectric characteristics of the piezoelectric element 300. Thus, the first perovskite layer 171 and the second perovskite layer 172 preferably have a thickness as thin as possible. Each of the first perovskite layer 171 and the second perovskite layer 172 is preferably thinner than at least the piezoelectric layer 70 and the total difference thereof is further preferably thinner than the piezoelectric layer 70. Specifically, the thickness thereof is set to be equal to or smaller than 100 nm, preferably equal to or smaller than 70 nm, and more preferably equal to or smaller than 50 nm.

It is preferable that the first perovskite layer 171 and the second perovskite layer 172, in particular, the first perovskite layer 171 as a base layer of the piezoelectric layer 70 be preferentially oriented to the (100) plane. This is because preferential orientation of the first perovskite layer is preferable for preferential orientation of the piezoelectric layer 70 to the (100) plane.

In a case where the first perovskite layer 171 has difficulty in self-orientation to the (100) plane, the first perovskite layer 171 may be preferentially oriented to the (100) plane in a manner that the orientation control layer is provided on the base of the first perovskite layer 171 and orientation control by the orientation control layer is performed.

Examples of the material of such an orientation control layer can include a compound oxide which has a perovskite structure, includes bismuth (Bi) in the A site and iron (Fe) and titanium (Ti) in the B site, and performs self-orientation to the (100) plane.

In addition, the piezoelectric layer 70 may be preferentially oriented to the (100) plane in a manner that the orientation control layer is provided between the first perovskite layer 171 and the piezoelectric layer 70 and orientation control by the orientation control layer is performed.

As such an orientation control layer, a layer including crystals of a compound oxide (perovskite type compound oxide) which includes potassium (K), sodium (Na), calcium (Ca), and niobium (Nb) and has a perovskite structure allowing preferential orientation to the (100) plane can be exemplified. The perovskite type compound oxide is formed of a compound oxide (referred to as "KNCN") which includes K, Na, and Ca in the A site and includes Nb in the B site. The perovskite type compound oxide is preferentially oriented to the (100) plane without depending on the state (crystal state and the like) of the base layer and causes the piezoelectric layer 70 which has a perovskite structure and is formed on the base layer to be preferentially oriented to the (100) plane, that is, functions as the orientation control layer.

Further, the first perovskite layer 171 may be preferentially oriented to the (100) plane in a manner that the orientation control layer, or the orientation control layer and an adhesive layer is provided on the base layer of the first electrode 60 and the first electrode 60 is preferentially oriented to the (100) plane.

Examples of such an orientation control layer can include a layer formed of a compound oxide including at least one or more selected from bismuth, manganese, iron, and titanium, and preferably a layer formed of a compound oxide which includes bismuth and manganese, or includes bismuth, manganese, and iron, or includes bismuth, iron, and titanium. Since the above orientation control layer is provided, the first electrode 60 formed on the orientation control layer can be preferentially oriented to the (100) plane. Preferably, the first electrode 60 may be preferentially oriented to the (100) plane through an adhesive layer, in a manner that the adhesive layer is provided between the orientation control layer and the first electrode 60 and the adhesive layer is preferentially oriented to the (100) plane by the orientation control layer.

As such an adhesive layer, a layer of which orientation is controlled by the orientation control layer and which is formed of at least one or more compound oxides selected from bismuth, manganese, iron, and titanium can be exemplified. Since the adhesive layer is set to have a perovskite structure, matching properties between metal (first electrode 60) formed on the adhesive layer and the lattice constant becomes favorable and adhesiveness between the vibration plate and the first electrode 60 is improved.

Regarding the thicknesses of various orientation control layers described above, any value may be provided so long as the thickness allows a layer formed on the orientation control layer to be preferentially oriented to the (100) plane. The thickness of the orientation control layer is 5 nm to 40 nm and preferably 5 nm to 15 nm. The orientation control layer having such a thickness may be provided to have an island shape, for example. "The island shape" means a state where a plurality of crystal grains are formed to be separate from each other.

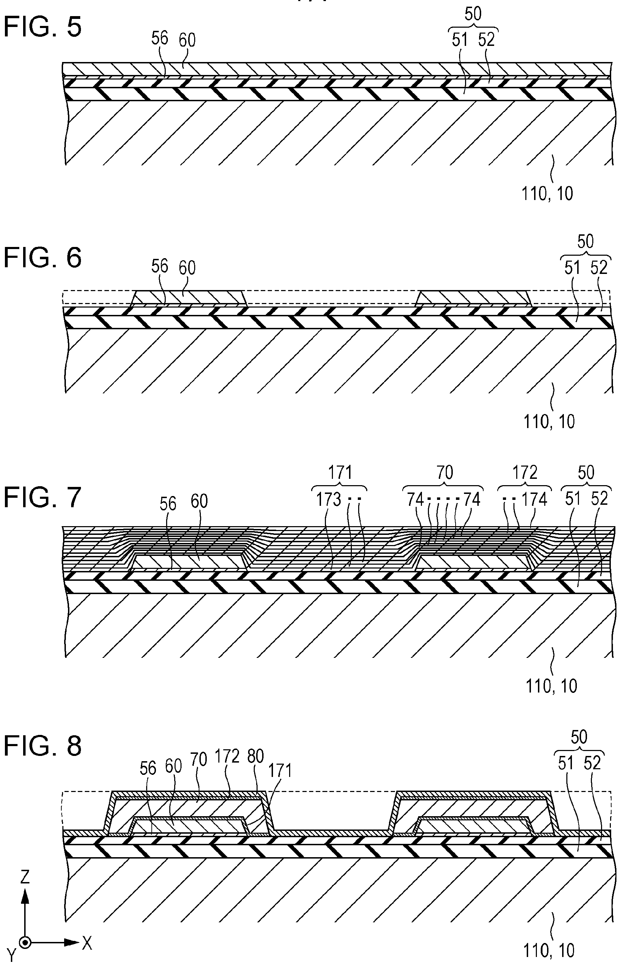

Next, an example of a manufacturing method of a piezoelectric element 300 will be described with reference to Figs. 5 to 11. The descriptions will be made with a manufacturing method of the ink jet recording head 1. Firstly, a silicon substrate (also referred to as "a wafer" below) 110 is prepared. Then, the silicon substrate 110 is thermally oxidized, and thus an elastic film 51 formed of silicon dioxide is formed on the silicon substrate 110. A zirconium film is formed on the elastic film 51 by sputtering, and the zirconium film is thermally oxidized. Thus, an insulating film 52 is formed. In this manner, a vibration plate 50 configured from the elastic film 51 and the insulating film 52 is obtained. Then, an adhesive layer 56 formed of titanium oxide is formed on the insulating film 52 by using a sputtering method or by thermally oxidizing a titanium film. Thus, as illustrated in Fig. 5, a first electrode 60 is formed on the adhesive layer 56 by using a sputtering method, an evaporation method, or the like.

Then, as illustrated in Fig. 6, a resist (not illustrated) having a predetermine shape is formed as a mask on the first electrode 60. The adhesive layer 56 and the first electrode 60 are simultaneously patterned. Then, as illustrated in Fig. 7, a plurality of first perovskite layers 171 and piezoelectric films 74 are formed so as to be superposed on the adhesive layer 56, the first electrode 60, and the vibration plate 50. The second perovskite layer 172 is formed. The piezoelectric layer 70 is formed by the plurality of piezoelectric films 74. The first perovskite layer 171 is configured by a plurality of layers and the second perovskite layer 172 is also configured by a plurality of layers. The piezoelectric layer 70, the first perovskite layer 171, and the second perovskite layer 172 may be formed by using a solution method (chemical solution method) such as a MOD method and a sol-gel method, for example. The piezoelectric layer 70, the first perovskite layer 171, and the second perovskite layer 172 are formed by using such a solution method, and thus it is possible to improve the productivity of the piezoelectric layer 70. The piezoelectric layer 70 formed by using such a solution method is formed by repeating a series of processes a plurality of number of times. The series of processes includes processes from a process (coating process) of performing coating with a precursor solution to a process (baking process) of baking the precursor film.

Specific procedures in a case where the piezoelectric layer 70, the first perovskite layer 171, and the second perovskite layer 172 are formed by using the solution method are as follows, for example. Firstly, a precursor solution containing a predetermined metal complex is prepared. In the precursor solution of the piezoelectric layer 70, a metal complex for forming a compound oxide containing K, Na, and Nb by baking is dissolved or dispersed in an organic solvent. At this time, a metal complex containing an additive such as Mn may be mixed.

Examples of the metal complex containing K include potassium 2-ethylhexanoate, and potassium acetate. Examples of the metal complex containing Na include sodium 2-ethylhexanoate, and sodium acetate. Examples of the metal complex containing Nb include 2-ethyl hexane acid niobium and pentaethoxy niobium. In a case where Mn is added as the additive, examples of the metal complex containing Mn include manganese 2-ethylhexanoate. At this time, two or more types of metal complex may be used together. For example, as the metal complex containing K, potassium 2-ethylhexanoate and potassium acetate may be used together. As a solvent, 2-n-butoxyethanol, n-octane, a solvent mixture of 2-n-butoxyethanol and n-octane, and the like are exemplified. The precursor solution may contain an additive agent for stabilizing dispersion of the metal complex containing K, Na, and Nb. As such an additive agent, 2-ethyl hexane acid and the like are exemplified.

The precursor solution of the first perovskite layer 171 and the second perovskite layer 172 is obtained in a manner that metal complexes for forming compound oxide layers 173 and 174 including Bi and Fe by baking are mixed with each other and the mixture is dissolved or dispersed in an organic solvent. As the metal complex which includes Bi and Fe, for example, alkoxide, an organic acid salt, a β diketone complex, and the like may be used. Examples of the metal complex including Bi include bismuth 2-ethylhexanoate and bismuth acetate. Examples of the metal complex including Fe include iron 2-ethylhexanoate, iron acetate, and tris(acetylacetonate) iron. Examples of the solvent for the precursor solution include propanol, butanol, pentanol, hexanol, octanol, ethylene glycol, propylene glycol, octane, decane, cyclohexane, xylene, toluene, tetrahydrofuran, acetic acid, and octylic acid.

The coating with the precursor solution is performed on the wafer 110 on which the vibration plate 50, the adhesive layer 56, and the first electrode 60 are formed, thereby a precursor film is formed (coating process). Then, the precursor film is heated to a predetermined temperature, for example, to a temperature of about 130°C to 250°C and is dried for a predetermined period (drying process). Then, the dried precursor film is heated to a predetermined temperature, for example, to a temperature of about 300°C to 450°C, and is held for a predetermined period, and thereby being degreased (degreasing process). Finally, if the degreased precursor film is heated to a higher temperature, for example, to a temperature of 600°C to 800°C, and is held at this temperature, and thereby being crystallized, the compound oxide layer 173, the piezoelectric film 74, and the compound oxide layer 174 are completed (baking process). It is appropriate that a heating rate in the drying process is set to be 30°C/sec to 350°C/sec. The piezoelectric film 74 is baked at such a heating rate by using the solution method, and thus it is possible to realize the piezoelectric layer 70 which is not pseudo-cubic. The "heating rate" stated herein defines a time change rate of the temperature when the temperature reaches a desired baking temperature from 350°C.

As a heating device used in the drying process, the degreasing process, and the baking process, for example, a rapid thermal annealing (RTA) device, a hot plate, and the like are exemplified. The RTA device performs heating by irradiation with an infrared lamp. The above processes are repeated plural number of times so as to form the first perovskite layer 171, the piezoelectric layer 70, and the second perovskite layer 172 formed with a plurality of compound oxide layers 173, a plurality of piezoelectric films 74, and a plurality of compound oxide layers 174. In the series of the processes from the coating process to the baking process, the processes from the coating process to the degreasing process may be repeated a plurality of number of times, and then, the baking process may be performed.

Before or after the second electrode 80 is formed on the first perovskite layer 171, the piezoelectric layer 70, and the second perovskite layer 172, if necessary, re-heating treatment (post annealing) may be performed in a temperature range of 600°C to 800°C. It is possible to form a favorable interface between the first perovskite layer 171 and the second perovskite layer 172, and the first electrode or the second electrode 80, and to improve crystallinity of the first perovskite layer 171, the piezoelectric layer 70, and the second perovskite layer 172, by performing such post annealing.

In the embodiment, the piezoelectric material contains alkali metal (K or Na). The alkali metal is easily diffused in the first electrode 60 or the adhesive layer 56, in the baking process. If the alkali metal reaches the wafer 110 through the first electrode 60 and the adhesive layer 56, the alkali metal is caused to react with the wafer 110. However, in the embodiment, the insulating film 52 formed from the zirconium oxide layer conducts the stopper function of K or Na. Thus, it is possible to suppress reaching of the alkali metal to the wafer 110 which is a silicon substrate.

Then, the first perovskite layer 171, the piezoelectric layer 70, and the second perovskite layer 172 which are respectively formed with the plurality of compound oxide layers 173, the plurality of piezoelectric films 74, and the plurality of compound oxide layers 174 are patterned, and thereby a shape as illustrated in Fig. 8 is obtained. Patterning may be performed by using dry etching such as reactive ion etching and ion milling, or wet etching in which an etching liquid is used. Then, the second electrode 80 is formed on the first perovskite layer 171, the piezoelectric layer 70, and the second perovskite layer 172. The second electrode 80 may be formed by using a method similarly to the first electrode 60. With the above processes, the piezoelectric element 300 which includes the first electrode 60, the first perovskite layer 171, the piezoelectric layer 70, the second perovskite layer 172, and the second electrode 80 is completed. In other words, a portion at which the first electrode 60, the first perovskite layer 171, the piezoelectric layer 70, the second perovskite layer 172, and the second electrode 80 overlap each other functions as the piezoelectric element 300.

A layer or a film formed by the solution method has an interface. Traces of coating or baking remains on the layer or the film formed by the solution method. Such a trace functions as "an interface" which can be confirmed by observing the section of the trace or by analyzing concentration distribution of an element in the layer (or in the film). The "interface" strictly means a boundary between layers or between films. However, here, it is assumed that the interface means the vicinity of a boundary between layers or between films. In a case where the section of a layer of a film formed by the solution method is observed by an electronic microscope or the like, such an interface is confirmed in the vicinity of a boundary with the adjacent layer or with the adjacent film, as a portion having a color darker than those of other portions, or as a portion having a color lighter than those of other portions. In a case where the concentration distribution of an element is analyzed, such an interface is confirmed in the vicinity of a boundary with the adjacent layer or with the adjacent film, as a portion at which the concentration of the element is higher than that at other portions, or as a portion at which the concentration of the element is lower than that at other portions. The piezoelectric layer 70 is formed in a manner that a series of processes from the coating process to the baking process are repeated a plurality of number of times, or in a manner that processes from the coating process to the degreasing process are repeated a plurality of number of times, and then the baking process is performed (configured by a plurality of piezoelectric films). Thus, the piezoelectric layer 70 has a plurality of interfaces for each piezoelectric film.

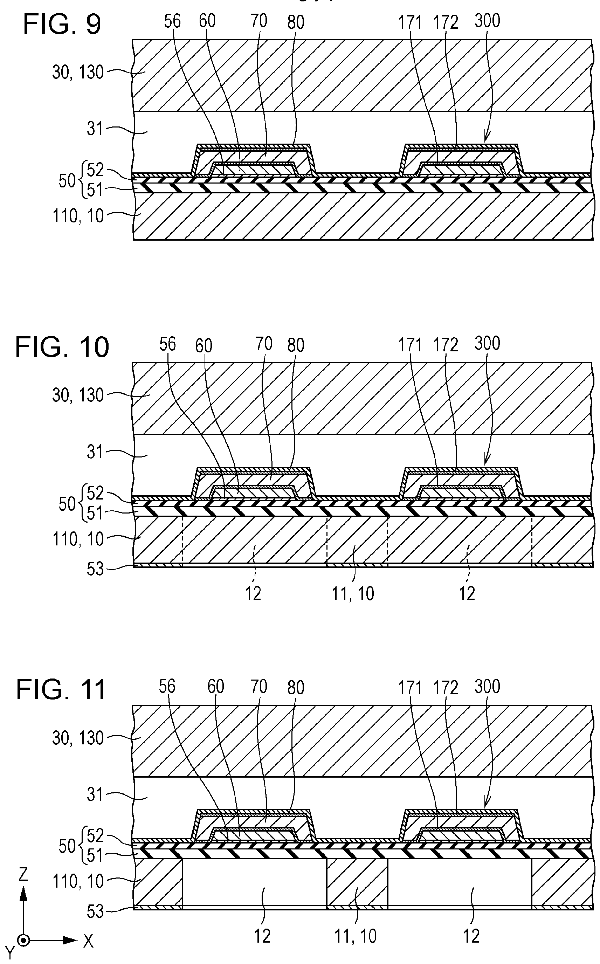

Then, as illustrated in Fig. 9, a wafer 130 for the protective substrate is bonded to a surface on the piezoelectric element 300 side of the wafer 110, through the adhesive 35 (see Fig. 4). Then, the surface of the wafer 130 for the protective substrate is abraded so as to become thin. The manifold portion 32 or the through-hole 33 (see Fig. 4) is formed on the wafer 130 for the protective substrate. Then, as illustrated in Fig. 10, a mask film 53 is formed on a surface of the wafer 110 on an opposite side of the piezoelectric element 300 and is patterned so as to have a predetermined shape. As illustrated in Fig. 11, anisotropic etching (wet etching) with an alkaline solution such as KOH is performed on the wafer 110 through the mask film 53. Thus, the ink supply path 13, the communication path 14, and the communication portion 15 (see Fig. 4) are formed in addition to the pressure generation chamber 12 corresponding to each piezoelectric element 300.

Then, an unnecessary portion of an outer circumferential portion of the wafer 110 and the wafer 130 for the protective substrate is cut out and removed by dicing and the like. The nozzle plate 20 is bonded to the surface of the wafer 110 on the opposite side of the piezoelectric element 300 (see Fig. 4). The compliance substrate 40 is bonded to the wafer 130 for the protective substrate (see Fig. 4). With the process until here, an assembly of chips for the ink jet recording head 1 is completed. The assembly is divided for each of the chips, and thus, the ink jet recording head 1 is obtained.

### Examples

Examples of the invention will be described below.

### Example 1

A surface of a silicon substrate of 6 inches, which was used as the passage formation substrate 10 was thermally oxidized, and thus the elastic film 51 formed of silicon dioxide was formed on the silicon substrate. Then, a zirconium film was formed on the elastic film 51 by sputtering, and the zirconium film was thermally oxidized. Thus, the insulating film 52 formed of zirconium oxide was formed. Then, a film was formed on the insulating film 52 by a sputtering method and thermal oxidization was performed so as to form an adhesive layer 56 formed of titanium oxide. After a platinum film was formed on the adhesive layer 56 by using a sputtering method, the platinum film was patterned so as to have a predetermined shape. Thus, the first electrode 60 having a thickness of 50 nm was formed.

Then, the first perovskite layer 171 was formed by the following procedures. Firstly, mixing was performed by using a precursor solution formed of bismuth 2-ethylhexanoate and iron 2-ethylhexanoate, so as to obtain BiFeO₃, and the mixture was applied onto the layer by the spin coating method (coating process). Then, the resultant was dried (drying process) at 180°C and degreased (degreasing process) at 380°C. A heating treatment was performed at 550°C by using rapid thermal annealing (RTA) (baking process). Thus, a BFO-based first perovskite layer 171 having a film thickness of about 30 nm was manufactured.

Then, the piezoelectric layer 70 was formed by the following procedures. Firstly, mixing was performed so as to have a composition of (K_{0.4}Na_{0.6})(Nb_{0.995}Mn_{0.005})O₃, by using a solution which is formed of potassium 2-ethylhexanoate, sodium 2-ethyl hexanoate, niobium 2-ethylhexanoate, and manganese 2-ethylhexanoate. The mixture was applied onto the layer by the spin coating method (coating process). Then, the resultant was dried (drying process) at 180°C and degreased (degreasing process) at 380°C on a hot plate. A heating treatment was performed at 700°C by using a rapid thermal annealing (RTA) device (baking process). These processes from the coating process to the baking process were repeated 7 times. Thus, a KNN-based piezoelectric layer 70 having a film thickness of about 550 nm was manufactured.

Then, a BFO-based second perovskite layer 172 having a film thickness of about 30 nm was manufactured through procedures similar to those for the first perovskite layer 171.

A platinum film was formed on the second perovskite layer 172 by a sputtering method while heating was performed up to 200°C, and thereby a second electrode 80 having a thickness of 50 nm was formed.

Then, in order to improve adhesiveness between the platinum film and the second perovskite layer 172, re-heating (post annealing) was performed at 650°C by the RTA device for three minutes. Thus, a piezoelectric element in Example 1 was formed.

### Example 2

A piezoelectric element was formed in a manner similar to that in Example 1 except that an orientation control layer formed of Bi(Fe_{0.5}Ti_{0.5})O₃ was provided on a base layer of the first perovskite layer 171.

### Comparative Example 1

A piezoelectric element was formed in a manner similar to that in Example 1 except that the first perovskite layer 171 and the second perovskite layer 172 were not provided.

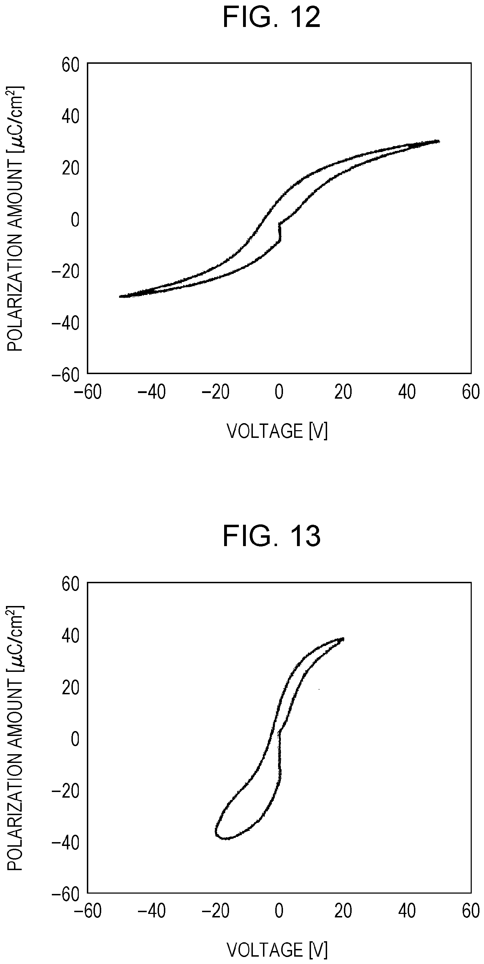

The following test was performed on the piezoelectric layer of the examples and the comparative examples which were described above. Table and Figs. 12 to 15 illustrate results.

### Hysteresis Measurement

P-E hysteresis of each of ceramic films in Example 1 and Comparative Example 1 was measured at a frequency of 1 kHz by using "FCE-1A" (manufactured by TOYO Corporation). Figs. 12 and 13 illustrate results. It was understood that a hysteresis curve showing a high insulating property and excellent hysteresis was drawn in Example 1 illustrated in Fig. 12, but a hysteresis curve showing a low insulating property and leakage was drawn in Comparative Example 1 illustrated in Fig. 13.

### XRD measurement

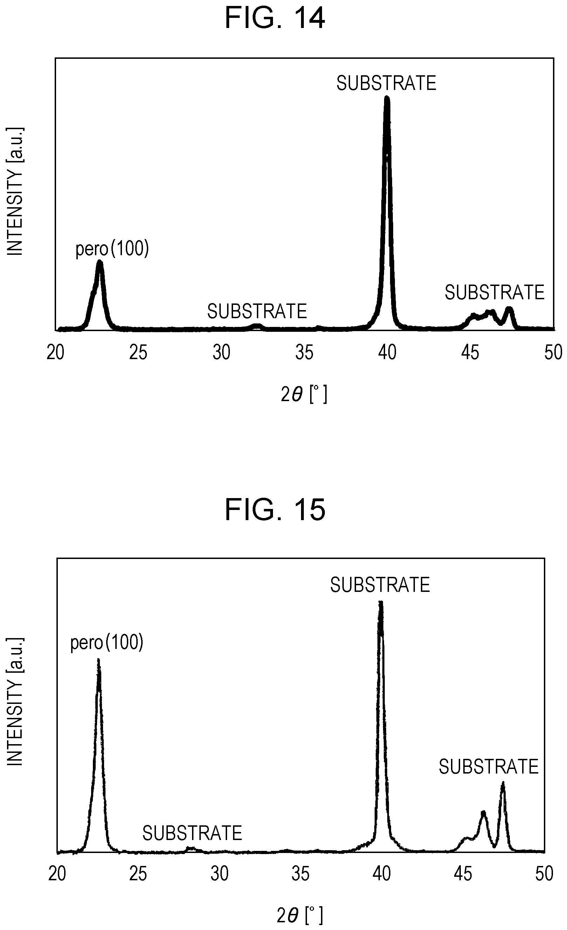

"D8 Discover" manufactured by Bruker AXS Corporation was used. Measurement was performed at room temperature by using Cu-Kα as a beam source and a two-dimensional detector (GADDS) as a detector. Figs. 14 and 15 illustrate results of Examples 1 and 2. As a result, as illustrated in Fig. 14, in the piezoelectric layer in Example 1, a peak for (100) plane orientation of perovskite was shown in a range of 2θ being in the vicinity of 22° to 23° and it was understood that the piezoelectric layer was preferentially oriented to the (100) plane. The piezoelectric layer in Comparative Example 1 was similar.

As illustrated in Fig. 15, it was confirmed that the piezoelectric layer in Example 2 was preferentially oriented to the (100) plane and a peak for (100) plane orientation of perovskite was higher than that in Example 1.

**Table**

| | Orientation | Leakage |
|---|---|---|
| Example 1 | B | B |
| Example 2 | A | B |
| Comparative Example 1 | B | C |

### Test Result

From the results in Figs. 12 to 15 and Table, it was understood that Examples 1 and 2 having a configuration in which the piezoelectric layer was interposed between the BFO-based first perovskite layer and second perovskite layer had a high insulating property and favorable leakage characteristics in comparison to Comparative Example 1 in which the first perovskite layer and the second perovskite layer were not provided.

### Other embodiments

Hitherto, the embodiment of the piezoelectric material or the piezoelectric element, and the liquid ejecting unit and the liquid ejecting apparatus which have the piezoelectric element mounted therein, according to the invention is described. However, the basic configuration of the invention is not limited to the above-described form. For example, in Embodiment 1, the silicon substrate as the passage formation substrate 10 is exemplified. However, it is not limited thereto, and may use, for example, an SOI substrate or a material such as glass.

In Embodiment 1, as an example of the liquid ejecting unit, the ink jet recording head is exemplified and described. However, the invention may be widely applied to all types of the liquid ejecting head and may be applied to a liquid ejecting unit which ejects a liquid other than an ink. Examples of such a liquid ejecting head include various recording heads used in an image recording apparatus such as a printer; a coloring material ejecting head used in manufacturing a color filter in a liquid crystal display and the like; an electrode material ejecting head used in forming an electrode in an organic EL display, a field emission display (FED), and the like; and a bio-organic material ejecting head used in manufacturing a bio-chip.

The invention is not limited to the piezoelectric element mounted in the liquid ejecting head and may be also applied to a piezoelectric element mounted in other piezoelectric element applied devices. As an example of the piezoelectric element applied device, an ultrasonic device, a motor, a pressure sensor, a pyroelectric element, and a ferroelectric element may be exemplified. A finished article using the piezoelectric element applied device, for example, an ejecting apparatus of a liquid and the like, which uses an ejecting head for the liquid and the like; an ultrasonic sensor using the ultrasonic device; a robot using the motor as a driving source; an IR sensor using the pyroelectric element; a ferroelectric memory using the ferroelectric element may be included as the piezoelectric element applied device.

The thickness, the width, the relative positional relationship, and the like of the constituents illustrated in the drawings, that is, the layers and the like may be exaggeratedly illustrated in describing the invention. The term of "being on" in the specification is not limited to the meaning that the positional relationship between the constituents is "just on". For example, an expression of "the first electrode on the substrate" or "the piezoelectric layer on the first electrode" includes a case where other constituents are provided between the substrate and the first electrode or between the first electrode and the piezoelectric layer.

## Claims

1. A piezoelectric element (300) comprising:
a first electrode (60);
a second electrode (80);
a piezoelectric layer (70) which is provided between the first electrode and the second electrode, and is formed of a perovskite type oxide including at least one selected from the group consisting of potassium, sodium, bismuth, and niobium;
a first perovskite layer (171) which is provided between the piezoelectric layer and the first electrode, and is formed of a perovskite type oxide having a composition different from that of the piezoelectric layer; and
a second perovskite layer (172) which is provided between the piezoelectric layer and the second electrode and is formed of a perovskite type oxide having a composition different from that of the piezoelectric layer, **characterised in that**
the first perovskite layer (171) and the second perovskite layer (172) include at least one selected from the group consisting of bismuth and iron.

2. The piezoelectric element according to Claim 1,
wherein the piezoelectric layer (70) is preferentially oriented to a (100) plane.

3. The piezoelectric element according to any one of the preceding claims,
wherein the first perovskite layer (171) is formed of a perovskite type oxide including bismuth or iron and is preferentially oriented to a (100) plane.

4. The piezoelectric element according to Claim 3,
wherein an orientation control layer is provided between the first electrode (60) and the first perovskite layer (171) or between the first perovskite layer (171) and the piezoelectric layer (70).

5. The piezoelectric element according to any one of the preceding claims,
wherein the second perovskite layer (172) is formed of a perovskite type oxide including bismuth or iron and is preferentially oriented to a (100) plane.

6. The piezoelectric element according to any one of the preceding claims,
wherein each of the first perovskite layer (171) and the second perovskite layer (172) is thinner than the piezoelectric layer (70).

7. The piezoelectric element according to any one of the preceding claims,
wherein the first electrode (60) and the second electrode (80) are formed of at least one material selected from Pt, Ir, and oxides thereof.

8. The piezoelectric element according to any one of the preceding claims,
wherein a layer (52) formed of zirconium or zirconium oxide is provided between a substrate (10) on which the first electrode (60) is provided, and the first electrode.

9. A piezoelectric element applied device (1) comprising:
the piezoelectric element (300) according to any one of the preceding claims.

## Patentansprüche

1. Piezoelektrisches Element (300), umfassend:
eine erste Elektrode (60);
eine zweite Elektrode (80);
eine piezoelektrische Schicht (70), die zwischen der ersten Elektrode und der zweiten Elektrode bereitgestellt ist und aus einem Oxid vom Perowskit-Typ gebildet ist, enthaltend mindestens eines, ausgewählt aus der Gruppe, bestehend aus Kalium, Natrium, Bismut und Niobium;
eine erste Perowskitschicht (171), die zwischen der piezoelektrischen Schicht und der ersten Elektrode bereitgestellt ist und aus einem Oxid vom Perowskit-Typ gebildet ist, das eine Zusammensetzung hat, die sich von der der piezoelektrischen Schicht unterscheidet; und
eine zweite Perowskitschicht (172), die zwischen der piezoelektrischen Schicht und der zweiten Elektrode bereitgestellt ist und aus einem Oxid vom Perowskit-Typ gebildet ist, das eine Zusammensetzung hat, die sich von der der piezoelektrischen Schicht unterscheidet, **dadurch gekennzeichnet, dass**
die erste Perowskitschicht (171) und die zweite Perowskitschicht (172) mindestens eines enthalten, ausgewählt aus der Gruppe, bestehend aus Bismut und Eisen.

2. Piezoelektrisches Element nach Anspruch 1,
wobei die piezoelektrische Schicht (70) bevorzugt zu einer (100) Ebene ausgerichtet ist.

3. Piezoelektrisches Element nach einem der vorangehenden Ansprüche,
wobei die erste Perowskitschicht (171) aus einem Oxid vom Perowskit-Typ gebildet ist, enthaltend Bismut oder Eisen, und bevorzugt zu einer (100) Ebene ausgerichtet ist.

4. Piezoelektrisches Element nach Anspruch 3,
wobei eine Ausrichtungssteuerungsebene zwischen der ersten Elektrode (60) und der ersten Perowskitschicht (171) oder zwischen der ersten Perowskitschicht (171) und der piezoelektrischen Schicht (70) bereitgestellt ist.

5. Piezoelektrisches Element nach einem der vorangehenden Ansprüche,
wobei die zweite Perowskitschicht (172) aus einem Oxid vom Perowskit-Typ gebildet ist, enthaltend Bismut oder Eisen, und bevorzugt zu einer (100) Ebene ausgerichtet ist.

6. Piezoelektrisches Element nach einem der vorangehenden Ansprüche,
wobei die erste Perowskitschicht (171) und die zweite Perowskitschicht (172) jeweils dünner als die piezoelektrische Schicht (70) sind.

7. Piezoelektrisches Element nach einem der vorangehenden Ansprüche,
wobei die erste Elektrode (60) und die zweite Elektrode (80) aus mindestens einem Material gebildet sind, ausgewählt aus Pt, Ir und Oxiden davon.

8. Piezoelektrisches Element nach einem der vorangehenden Ansprüche,
wobei eine Schicht (52), die aus Zirkonium oder Zirkoniumoxid gebildet ist, zwischen einem Substrat (10), an dem die erste Elektrode (60) bereitgestellt ist, und der ersten Elektrode bereitgestellt ist.

9. Vorrichtung mit angebrachtem piezoelektrischen Element (1), umfassend:
das piezoelektrische Element (300) nach einem der vorangehenden Ansprüche.

## Revendications

1. Élément piézo-électrique (300) comprenant :
une première électrode (60) ;
une seconde électrode (80) ;
une couche piézo-électrique (70) qui est prévue entre la première électrode et la seconde électrode, et est formée d'un oxyde de type pérovskite incluant au moins un élément sélectionné dans le groupe composé de potassium, sodium, bismuth et niobium ;
une première couche de pérovskite (171) qui est prévue entre la couche piézo-électrique et la première électrode, et est formée d'un oxyde de type pérovskite ayant une composition différente de celle de la couche piézo-électrique ; et
une seconde couche de pérovskite (172) qui est prévue entre la couche piézo-électrique et la seconde électrode et est formée d'un oxyde de type pérovskite ayant une composition différente de celle de la couche piézo-électrique, **caractérisé en ce que**
la première couche de pérovskite (171) et la seconde couche de pérovskite (172) incluent au moins un élément sélectionné dans le groupe composé du bismuth et du fer.

2. Élément piézo-électrique selon la revendication 1,
dans lequel la couche piézo-électrique (70) est de préférence orientée en un plan (100).

3. Élément piézo-électrique selon l'une quelconque des revendications précédentes,
dans lequel la première couche de pérovskite (171) est formée sur un oxyde de type pérovskite contenant du bismuth ou du fer et est de préférence orientée en un plan (100).

4. Élément piézo-électrique selon la revendication 3,
dans lequel une couche de contrôle d'orientation est prévue entre la première électrode (60) et la première couche de pérovskite (171) ou entre la première couche de pérovskite (171) et la couche piézo-électrique (70) .

5. Élément piézo-électrique selon l'une quelconque des revendications précédentes,
dans lequel la seconde couche de pérovskite (172) est formée sur un oxyde de type pérovskite contenant du bismuth ou du fer et est de préférence orientée en un plan (100).

6. Élément piézo-électrique selon l'une quelconque des revendications précédentes,
dans lequel chacune parmi la première couche de pérovskite (171) et la seconde couche de pérovskite (72) est plus mince que la couche piézo-électrique (70) .

7. Élément piézo-électrique selon l'une quelconque des revendications précédentes,
dans lequel la première électrode (60) et la seconde électrode (80) sont formées d'au moins un matériau sélectionné parmi le Pt, l'Ir et leurs oxydes.

8. Élément piézo-électrique selon l'une quelconque des revendications précédentes,
dans lequel une couche (52) formée de zirconium ou d'oxyde de zirconium est prévue entre un substrat (10) sur lequel la première électrode (60) est prévue et la première électrode.

9. Dispositif (1) appliquée sur un élément piézo-électrique, comprenant :
l'élément piézo-électrique (300) selon l'une quelconque des revendications précédentes.
